(19) **Europäisches Patentamt / European Patent Office / Office européen des brevets**

(11) **EP 3 954 746 B1**

(12) **EUROPEAN PATENT SPECIFICATION**

(45) Date of publication and mention of the grant of the patent:
**27.12.2023 Bulletin 2023/52**

(21) Application number: **20907106.7**

(22) Date of filing: **07.12.2020**

(51) International Patent Classification (IPC):
*C09J 7/10* (2018.01)      *C09J 7/38* (2018.01)
*C09J 133/08* (2006.01)      *H01L 21/56* (2006.01)

(52) Cooperative Patent Classification (CPC):
(C-Sets available)
**C09J 133/08; C09J 7/10; C09J 7/385;**
**H01L 21/561; H01L 21/568;** C08F 220/1804;
C09J 2203/326; C09J 2301/302; C09J 2433/00;
H01L 21/565; H01L 24/16; H01L 24/29; H01L 24/32;
H01L 24/45; H01L 24/48;                    (Cont.)

(86) International application number:
**PCT/JP2020/045534**

(87) International publication number:
**WO 2021/131650 (01.07.2021 Gazette 2021/26)**

(54) **USE OF A VISCOUS ADHESIVE TAPE**

VERWENDUNG EINES VISKOSEN KLEBEBANDES

UTILISATION D'UN RUBAN ADHÉSIF VISQUEUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2019 JP 2019238895**

(43) Date of publication of application:
**16.02.2022 Bulletin 2022/07**

(73) Proprietor: **Arisawa Mfg. Co., Ltd.**
**Joetsu-shi, Niigata 943-8610 (JP)**

(72) Inventors:
• **ABE, Noriaki**
  **Joetsu-shi, Niigata 943-8610 (JP)**
• **SATO, Nobuyuki**
  **Joetsu-shi, Niigata 943-8610 (JP)**
• **YOSHIHARA, Hiromi**
  **Joetsu-shi, Niigata 943-8610 (JP)**
• **TACHIKAWA, Toru**
  **Joetsu-shi, Niigata 943-8610 (JP)**

(74) Representative: **Zacco Sweden AB**
**P.O. Box 5581**
**Löjtnantsgatan 21**
**114 85 Stockholm (SE)**

(56) References cited:
WO-A2-2009/018246      JP-A- 2007 326 899
JP-A- 2009 035 602      JP-A- 2013 512 303
JP-A- 2016 169 303      US-A1- 2012 274 881

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
H01L 24/73; H01L 24/78; H01L 24/81; H01L 24/83;
H01L 24/85; H01L 24/92; H01L 24/97;
H01L 2224/16245; H01L 2224/2919;
H01L 2224/32245; H01L 2224/45124;
H01L 2224/45144; H01L 2224/48091;
H01L 2224/48247; H01L 2224/73265;
H01L 2224/78251; H01L 2224/78744;
H01L 2224/81815; H01L 2224/83101;
H01L 2224/83913; H01L 2224/85001;
H01L 2224/85013; H01L 2224/85205;
H01L 2224/92247; H01L 2224/97; H01L 2924/181

C-Sets
**C09J 133/08, C08L 33/08, C08L 63/04;**
C08F 220/1804, C08F 220/06;
C08F 220/1804, C08F 220/20;
C09J 2433/00, C09J 2433/00;
H01L 2224/2919, H01L 2924/00014;
H01L 2224/45124, H01L 2924/00014;
H01L 2224/45144, H01L 2924/00014;
H01L 2224/48091, H01L 2924/00014;
H01L 2224/73265, H01L 2224/32245,
H01L 2224/48247, H01L 2924/00012;
H01L 2224/92247, H01L 2224/73265,
H01L 2224/32245, H01L 2224/48247,
H01L 2924/00012;
H01L 2224/97, H01L 2224/73265,
H01L 2224/32245, H01L 2224/48247,
H01L 2924/00012;
H01L 2224/97, H01L 2224/92247,
H01L 2224/73265, H01L 2224/32245,
H01L 2224/48247, H01L 2924/00012;
H01L 2924/181, H01L 2924/00012

**Description**

Technical Field

The present invention relates to use of a viscous adhesive tape production of semiconductor devices.

Background Art

In LSI packaging technology, CSP (Chip Size/Scale Package) technology is gathering attention. Among them, a package form with lead terminals incorporated inside a package, which is typified by QFN (Quad Flat Non-leaded package), is advantageous in regard to downsizing and high integration. As a production method of the QFN, a method including collectively sealing a plurality of semiconductor chips for QFN arranged on a die pad in a package pattern region of a leadframe by sealing resin in a mold cavity, and then cutting the semiconductor chips into individual QFN structures is employed to improve the productivity per leadframe area.

In the production method of QFN in which a plurality of semiconductor chips are collectively sealed, the region clamped by a mold during resin sealing is only a region further outside a resin sealing region spreading outside the package pattern region. Therefore, the sealing resin leaking out on the rear face of a leadframe tends to cause problems such as connection failure resulting from burrs of a molding resin and QFN terminals coated with resin. In the production method of QFN, prevention of the resin leakage to the rear face of a leadframe during resin sealing by a sealing effect with use of self-bonding force (masking) of a heat-resistant adhesion tape stuck to the rear face of the leadframe is therefore considered to be effective.

In such a production method, a method involving laminating a viscous adhesive tape after mounting of semiconductor chips on a leadframe or after wire-bonding, or a method involving laminating a viscous adhesive tape on the rear face (outer pad face) of a leadframe in a first stage, and then, following a step of mounting semiconductor chips and a step of wire-bonding, performing a step of sealing with a sealing resin is employed. On this occasion, a production method involving performing a series of steps such as wire-bonding while preventing the resin from leaking by using a heat-resistant viscous adhesive tape having viscous adhesive layer is proposed (see JP 2002-184801).

JP 2010-157752 relates to a heat-resistant viscous adhesive tape with a viscous adhesive component containing a mold release agent, and reports that resin leakage in a sealing step can be thereby suitably prevented, and further, since the viscous adhesive layer contains a mold release agent, peeling is easy after the sealing step, and peeling and breakage of a molding resin caused by peeling stress can be prevented.

Moreover, US 2012/274881 relates to a pressure sensitive adhesive composition, a polarizer and a liquid crystal display device. The document may provide a pressure sensitive adhesive which can have excellent stress relaxation characteristic to effectively inhibit light leakage by dimension change of optical films such as polarizing plates. In addition, a pressure sensitive adhesive having excellent physical properties such as adhesion durability and workability.

Furthermore, WO 2009/018246 relates to providing a pressure-sensitive adhesive with good initial tack and good adhesion at low temperature. Generally, the pressure-sensitive adhesive composition comprises (1) a carboxylic group- containing (meth)acrylic tacky polymer having a weight average molecular weight of less than 800,000 and a glass transition temperature of -100° C to -30° C, and (2) an amino group- containing (meth)acrylic non-tacky polymer having a weight average molecular weight of from 30,000 to 100,000 and a glass transition temperature of 20° C to 90° C. The amino group-containing (meth)acrylic non-tacky polymer (2) is present in an amount of no less than 1 parts by mass and less than 20 parts by mass on a basis of 100 parts by mass of said carboxylic group- containing (meth)acrylic tacky polymer (1).

Summary of Invention

Technical Problem

When a leadframe for use in QFN is a PPF (pre-plated leadframe), physical polishing cannot be performed after peeling of a viscous adhesive tape. In other words, mechanical washing of a PPF cannot be performed, which causes problems including degradation of properties such as soldering failure and degradation of yield due to discoloration, resulting from adhesive residues that cannot be identified by visual observation.

In regard to this point, with use of a silicone resin as the tack layer of a viscous adhesive tape, thermal decomposition easily occurs to cause a problem of pollution by siloxane gas after a sealing step. Alternatively, with use of an acrylic resin as a tack layer, although pollution can be prevented by sufficient progress of the cross-linking reaction, the adhesion strength required for suppressing burrs of a molding resin in the sealing step decreases.

Further, the viscous adhesive tape disclosed in JP 2010-157752 is still unsatisfactory from the viewpoint of compatibility between adhesion properties and prevention of adhesive residues, though having good adhesion properties.

It is an object of the present invention, in the light of these circumstances, to provide a viscous adhesive tape capable of preventing occurrence of burrs of a molding resin in the sealing step, without adhesive residues in the tape peeling step, and achieving compatibility between adhesion properties and pollutionresistant properties.

Solution to Problem

Through intensive studies to solve the problem, the present inventors have found that a viscous adhesive tape containing at least two acrylic resins having an acid value in a specific range at a specific ratio, and having a semi-interpenetrating polymer network structure can solve the problem, so that the present invention has been completed.

In other words, the present invention relates to the use of a viscous adhesive tape for production of semiconductor devices, wherein the viscous adhesive tape comprises a tack layer containing a first acrylic resin having an acid value of 30 to 100 mg KOH/g and a second acrylic resin having an acid value of 0 to 10 mg KOH/g, wherein a ratio between the first acrylic resin and the second acrylic resin is,

(First acrylic resin):(Second acrylic resin)=85:15 to 65:35, and
the first acrylic resin and the second acrylic resin have a semi-interpenetrating polymer network structure, said polymer network structure being a mixture of crosslinked polymer networks,
wherein the tack layer further contains a curing agent and is obtained by curing the first acrylic resin by the curing agent, and
wherein the curing agent is an epoxy resin.

The use of the viscous adhesive tape according to the invention, wherein the first acrylic resin has a molecular weight distribution (Mw/Mn) of 2.0 or less, and the second acrylic resin has a molecular weight distribution (Mw/Mn) of 2.0 or less.

The use of the viscous adhesive tape according to the invention, wherein the first acrylic resin has a weight average molecular weight (Mw) of 400000 to 1000000, and the second acrylic resin has a weight average molecular weight (Mw) of 400000 to 800000.

The use of the viscous adhesive tape according to the invention, wherein the tack layer further contains a curing agent and is obtained by curing the first acrylic resin by the curing agent.

The use of the viscous adhesive tape according to the invention, wherein the curing agent is an epoxy resin. The use of the viscous adhesive tape according to the invention, wherein the content of the curing agent is 0.4 to 0.6 equivalents relative to the first acrylic resin. The use of the viscous adhesive tape according to the invention, wherein the tack layer further contains a curing catalyst.

The use of the viscous adhesive tape according to the invention, wherein the viscous adhesive tape is used for production of semiconductor devices.

Advantageous Effect of Invention

According to the present invention, a viscous adhesive tape capable of preventing occurrence of burrs of a molding resin in a sealing step, without adhesive residues in a tape peeling step, and achieving compatibility between adhesion properties and pollutionresistant properties can be provided.

Brief Description of Drawing

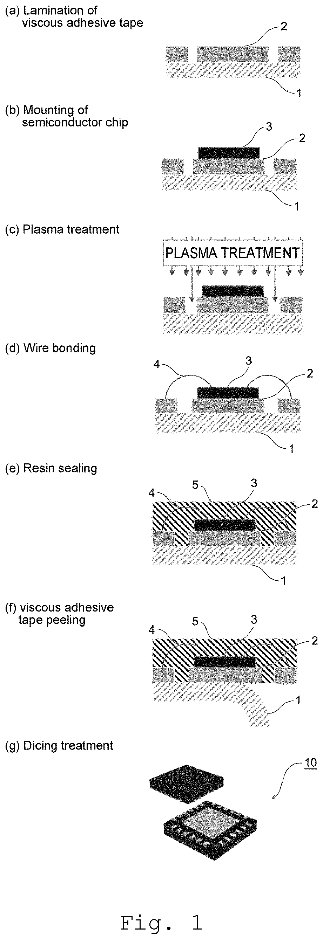

[Figure 1] Figure 1 is a process chart showing a production method of semiconductor devices, using a viscous adhesive tape of the present invention.

Description of Embodiments

An embodiment of the present invention (hereinafter, referred to simply as "present embodiment") is described in detail as follows. The following present embodiment is provided to illustrate the invention. The present invention may be appropriately modified within the scope of the present invention. Incidentally, unless otherwise noted in the present specification, "(meth)acrylic" means "acrylic" and/or "methacrylic", and in the same manner, "(meth)acryloyl" means "acryloyl" and/or "methacryloyl", and "(meth)acrylate" means "acrylate" and/or "methacrylate". Further, "curing" includes not only complete curing but also semi-curing.

The use of the viscous adhesive tape in the present embodiment is a viscous adhesive tape comprising a tack layer containing a first acrylic resin having an acid value of 30 to 100 mg KOH/g and a second acrylic resin having an acid value of 0 to 10 mg KOH/g or less, wherein a ratio between the first acrylic resin and the second acrylic resin is

(First acrylic resin):(Second acrylic resin)=85:15 to 65:35, and the first acrylic resin and the second acrylic resin have a semi-interpenetrating polymer network structure.

The first acrylic resin and the second acrylic resin that are contained in the tack layer of a viscous adhesive tape of the present embodiment have a semi-interpenetrating polymer network structure. The "interpenetrating polymer network" is a mixture having a network structure in which different types of cross-linked polymer networks penetrate to each other, also abbreviated as IPN. The semi-interpenetrating polymer network (semi-IPN) in the present embodiment has a structure including a component in a straight chain form (or an approximately straight chain form) and another component in a cross-linked polymer network form, with a part or the whole of the acrylic resin in a straight chain form penetrating into the other acrylic resin in a cross-linked polymer network form.

Due to having the structure described above, the viscous adhesive tape in the present embodiment allows the second acrylic resin to be held in the cross-linked polymer network structure of the first acrylic resin, so that occurrence of adhesive residues caused by leakage of the second acrylic resin can be prevented. Further, due to the second acrylic resin having no crosslinking or a low crosslinking density, adhesion strength at high temperature can be enhanced, so that occurrence of resin burrs caused by leakage of the sealing resin can be prevented.

[Acrylic resin]

Examples of the acrylic resin contained in a viscous adhesive tape of the present embodiment include a copolymer containing a (meth)acrylic acid ester and an unsaturated carboxylic acid as constituent units, and a copolymer containing a (meth)acrylic acid ester and an unsaturated carboxylic acid as constituent units and having a carboxyl group and a (meth)acryloyl group in a side chain is preferred.

Examples of monomers having an unsaturated carboxylic acid include (meth)acrylic acid, crotonic acid, maleic acid and itaconic acid. When the acrylic resin is a copolymer containing a (meth)acrylic acid ester and (meth)acrylic acid as constituent units, two or more (meth)acrylic acid esters may be used, or methacrylic acid and acrylic acid may be used as two (meth)acrylic acids.

As the acrylic resin described above, one having a carboxyl group and an ethylenic unsaturated bond may be used, and examples thereof include an acrylic resin containing, as a monomer, at least any one of a (meth)acrylic acid alkyl ester such as methyl (meth)acrylate, ethyl (meth)acrylate, n-propyl (meth)acrylate, i-propyl (meth)acrylate, n-butyl (meth)acrylate, i-butyl (meth)acrylate, s-butyl (meth)acrylate, t-butyl (meth)acrylate, n-pentyl (meth)acrylate, i-pentyl (meth)acrylate, hexyl (meth)acrylate, heptyl (meth)acrylate, isoamyl (meth)acrylate, 2-ethylhexyl (meth)acrylate, n-octyl (meth)acrylate, i-octyl (meth)acrylate, n-nonyl (meth)acrylate, i-nonyl (meth)acrylate, n-decyl (meth)acrylate, i-decyl (meth)acrylate, n-dodecyl (meth)acrylate, n-tetradecyl (meth)acrylate, stearyl, and i-stearyl (meth)acrylate; a (meth)acrylic acid hydroxyalkyl ester such as 2-hydroxyethyl (meth)acylate, 2-hydroxypropyl (meth)acrylate, and 3-hydroxypropyl (meth)acrylate; acrylamides such as acrylamide, methacrylamide, N-methyl acrylamide, and N-methyl methacrylamide; and an acrylic acid monoalkyl amino ester such as monomethyl aminoethyl, monoethyl aminoethyl, monomethyl aminopropyl, and monoethyl aminopropyl.

In particular, from the viewpoint of further excellence in sticking to an adherend and initial followability, an acrylic resin containing n-butyl (meth)acrylate and/or 2-ethylhexyl (meth)acrylate is preferred. Incidentally, a functional group such as a hydroxyl group, an amino group and an amide group may be further contained in a range where the effect of the present embodiment is not lost.

The acrylic resin may further contain a constituent unit other than the (meth)acrylic acid esters and the unsaturated carboxylic acids.

The tack layer of an adhesive sheet in the present embodiment contains a first acrylic resin having a high acid value and a second acrylic resin having a low acid value. The first acrylic resin having a high acid value forms a polymer network structure having a high crosslinking density when crosslinked by a curing agent. On the other hand, the second acrylic resin having a low acid value forms a structure having a low crosslinking density, in a straight chain form or an approximately straight chain form, even when crosslinked by a curing agent.

The first acrylic resin has an acid value of 30 to 100 mg KOH/g, preferably 45 to 80 mg KOH/g. When the first acrylic resin has an acid value of less than 30 mg KOH/g, the risk of pollution caused by leakage of low-molecular weight components increases due to the insufficient crosslinking density. On the other hand, with an acid value of more than 100 mg KOH/g, unreacted acidic functional groups react with the sealing resin, so that the risk of heavy peeling increases after processing.

The second acrylic resin has an acid value of 0 to 10 mg KOH/g, preferably 0 to 5 mg KOH/g. It is particularly preferable that the acid value of the second acrylic resin be 0 mg KOH/g. However, the acid value of the second acrylic resin may be more than 0 mg KOH/g in a range where the effect of the present invention can be exhibited, and in that case, the second acrylic resin may react with the curing agent described below. With an acid value of the second acrylic resin of more than the upper limit of 10 mg KOH/g, the adhesion strength to the leadframe (outer pad surface) decreases at high temperature, so that the risk of occurrence of resin burrs increases.

The acid value may be measured by the method described in the following Examples.

Although the weight average molecular weight (Mw) of the acrylic resin is not particularly limited, it is preferable that the difference between the weight average molecular weight (Mw) of the first acrylic resin and the weight average molecular weight (Mw) of the second acrylic resin be 0 to 400000. With a difference in the weight average molecular weight between the first and second acrylic resins in the range described above, the compatibility between both of them is improved, so that the effect of the present invention tends to be further enhanced.

The weight average molecular weight of the first acrylic resin is preferably 400000 to 1000000, more preferably 600000 to 900000, from the viewpoint of adhesion strength.

The weight average molecular weight of the second acrylic resin is preferably 400000 to 800000 from the viewpoint of pollution resistance.

Regarding the molecular weight distribution of the acrylic resins, it is preferable that the molecular weight distribution (Mw/Mn) of the first acrylic resin be 2.0 or less and the molecular weight distribution (Mw/Mn) of the second acrylic resin be 2.0 or less. With the molecular weight distribution of the first and second acrylic resins in the ranges, the second acrylic resin is sufficiently and stably held in the internal part of the polymer network structure of the first acrylic resin, so that the effect of the present invention tends to be further enhanced.

The ratio between the first acrylic resin and the second acrylic resin contained in the tack layer of a viscous adhesive tape of the present invention is: (First acrylic resin):(Second acrylic resin)=85:15 to 65:35, and more preferably 80:20 to 70:30. With a too high ratio of the first acrylic resin contained in the tack layer, the risk of occurrence of burrs of the molding resin in a sealing step increases due to insufficient adhesion properties at high temperature. On the other hand, with a too high ratio of the second acrylic resin contained in the tack layer, adhesive residues occur in a tape peeling step, so that the risk of pollution of semiconductor devices increases.

[Production method of acrylic resin]

The production method of acrylic resins is not particularly limited, and a conventionally known method may be used.

For example, in production of the first acrylic resin having a high acidic value, a free radical polymerization method may be employed, and in production of the second acrylic resin having a low acidic value, living radical polymerization method may be employed.

[Curing agent]

In a viscous adhesive tape in the present embodiment, the tack layer further contains an epoxy resin curing agent and be obtained by curing the first acrylic resin by the curing agent. Although the second acrylic resin may be in a state cured by the curing agent or may be in an uncured state, an uncured state is preferred from the viewpoint of adhesion properties. From the viewpoint of reactivity, it is preferable that the epoxy resin have an epoxy equivalent of 90 to 300 g/eq.

Examples of the epoxy resin include a bisphenol A-type epoxy resin, a bisphenol F-type epoxy resin, a novolac-type epoxy resin, and an amine-type epoxy resin, and, in particular, from the viewpoint of heat resistance, a novolac-type epoxy resin and an amine-type epoxy resin are preferred. Further, from the viewpoint of compatibility with the first acrylic resin, a novolac-type epoxy resin is preferred. Further, the novolac-type epoxy resin has a number (n) of repeating units of preferably 2 to 10, more preferably 2 to 5.

As the isocyanate resin, a multi-functional isocyanate is preferred from the viewpoint of reactivity. Examples thereof include ethylene diisocyanate, butylene diisocyanate, hexamethylene diisocyanate, cyclopentylene diisocyanate, cyclohexylene diisocyanate, isophorone diisocyanate, 2,4-tolylene diisocyanate, diphenylmethane diisocyanate, xylylene diisocyanate, 4,4'-diphenylmethane diisocyanate, and dicyclohexylmethane diisocyanate.

The content of the curing agent contained in the tack layer in a viscous adhesive tape is not particularly limited, and preferably 0.4 to 0.6 equivalents relative to the first acrylic resin. With a content of the curing agent of 0.4 equivalents or more, crosslinking of the first acrylic resin proceeds sufficiently, so that the pollution resistance tends to be further improved. On the other hand, with a content of the curing agent of 0.6 equivalents or less, the adhesion properties tend to be further improved.

[Curing catalyst]

The tack layer of a viscous adhesive tape in the present embodiment may further contain a curing catalyst. It is preferable that a curing catalyst having an activation temperature of 120°C or less be used as the curing catalyst. Examples of the curing catalyst include an organic peroxide such as benzoyl peroxide, methyl ethyl ketone peroxide, t-butyl peroxy-2-ethylhexanoate, cumene hydroperoxide, cyclohexanone peroxide, and dicumyl peroxide; an imidazole initiator such as 2-methyl imidazole and N-benzyl-2-methyl imidazole; an azo initiator such as 2,2'-azobis-(2-methylbutyronitrile), 2,2'-azobisisobutyronitrile; a Lewis acid complex such as monoethylamine boron trifluoride; a polyamine and a melamine resin. Among these, an imidazole initiator such as 2-methyl imidazole and 2-undecyl imidazole is preferred from the viewpoint of pollution by catalyst residues.

It is preferable that the content of the curing catalyst relative to 100 parts by mass of an acrylic resin be 0.01 to 3 parts by mass. With a content of the curing catalyst of 3 parts by mass or less, the risk of pollution of an adherend tends to decrease, and with a content of 0.01 parts by mass or more, sufficient polymerization initiation tends to be achieved. The content of the curing catalyst relative to 100 parts by mass of an acrylic resin is more preferably 0.05 to 2 parts by mass, still more preferably 0.05 to 1 part by mass.

The tack layer of a viscous adhesive tape in the present embodiment may further contain other additives besides the above. Examples of the other additives include a mold release agent, a UV absorber, a tackifier, a softener, a filler, an anti-aging agent, a pigment, a dye, and a silane coupling agent.

[Viscous adhesive tape]

The use of the viscous adhesive tape in the present embodiment is a viscous adhesive tape having a tack layer containing the specific acrylic resins described above. The viscous adhesive tape may include a tack layer and a substrate layer.

For example, the viscous adhesive tape may be made by applying a resin composition constituting the tack layer in the present embodiment on a substrate (referred to also as base film) to form the tack layer.

The thickness of the tack layer of a viscous adhesive tape of the present invention is preferably 3 to 40 $\mu$m, more preferably 3 to 20 $\mu$m. With a thickness of the tack layer of 3 $\mu$m or more, sufficient sealing properties tend to be obtained in a sealing step. On the other hand, with a thickness of the tack layer of 40 $\mu$m or less, the tack layer is not broken by clamping pressure of a mold, so that the viscous adhesive tape tends to be stably produced.

On the other hand, the thickness of a substrate layer is not particularly limited, preferably 5 $\mu$m or more from the viewpoint of preventing bending and cracking, and more preferably 10 to 100 $\mu$m from the viewpoint of handling properties.

The material of the substrate layer is not particularly limited, and examples thereof include a polyethylene terephthalate (PET) substrate, a polyimide (PI) substrate, a polyamide (PA) substrate, a polyethylene naphthalate (PEN) substrate, and a polyphenylene ether sulfide (PPS) substrate. Among these, a polyimide substrate is preferred from the viewpoint of heat resistance, etc. Further, the substrate may be subjected to various surface modifying treatments such as a corona treatment and a plasma treatment. Thereby, the substrate may be prevented from changing in physical properties and may be subjected to various surface modifications.

Before use of a viscous adhesive tape in the present embodiment, the tack layer may be protected with a mold release film (separation film), etc. The lamination of such a mold release film contributes the tack strength of the tack layer to be maintained. The mold release film is not particularly limited, and known ones may be appropriately used. Examples of the mold release film include a polyethylene terephthalate film, a polypropylene film, a polyethylene film, and a mold release paper, which are processed with a silicone mold release treatment or a fluorine mold release treatment.

Examples of the production method of a viscous adhesive tape may include a method involving forming a tack layer on a substrate by preparing a solution dissolving a resin composition of the tack layer in an organic solvent, applying the solution on a substrate, and drying the applied solution.

Examples of the organic solvent include alcohols such as methanol and ethanol; glycols such as ethylene glycol and propylene glycol; glycol monoalkyl ethers such as ethylene glycol monomethyl ether and ethylene glycol monoethyl ether; a glycol dialkyl ether such as ethylene glycol dimethyl ether and ethylene glycol diethyl ether; alkyl esters such as methyl acetate, ethyl acetate, propyl acetate, methyl acetoacetate, and methyl acetoacetate; ketones such as acetone, methyl ethyl ketone, methyl isobutyl ketone, and cyclohexanone; aromatic hydrocarbons such as benzene, toluene, xylene, and ethylbenzene; aliphatic hydrocarbons such as hexane, cyclohexane, and octane; amides such as dimethylformamide, dimethylacetamide, and N-methylpyrrolidone; and cyclic ethers such as tetrahydrofuran and dioxane.

The coating method is not particularly limited, and a known method may be employed. For example, a die coater, a comma coater, and a gravure coater may be used.

[Production method of semiconductor device]

The use of a viscous adhesive tape according to the invention is stuck to a terminal area to be masked in resin sealing of electronic components or semiconductor parts.

Figure 1 is a process chart showing a production method of semiconductor devices in the present embodiment, using a viscous adhesive tape of the present invention. As shown in Figure 1, the production method of semiconductor devices includes at least a step of mounting a semiconductor chip 3 and a sealing step using a sealing resin 5. The production method of semiconductor devices may further include a dicing step for cutting a sealed structure.

As shown in Figure 1 (a) to (d), the mounting step is a step of bonding a semiconductor chip 3 onto a die pad of a leadframe 2 made of metal with a viscous adhesive tape 1 laminated on the rear side of the leadframe (underside in the drawing).

The leadframe 2 is a carved terminal pattern of QFN made of metal material such as copper, of which electrical contact part is coated (plated) with a material such as silver, nickel, palladium and gold in some cases. The thickness of the leadframe 2 is generally 100 to 300 $\mu$m. Incidentally, this does not apply to a partially thinned part by etching or the like. It is preferable that the leadframe 2 have systematic arrangement pattern of individual QFN, so as to be easily cut and divided in the subsequent cutting step.

It is preferable that the viscous adhesive tape 1 be stuck to at least the outside of the package pattern area, and to an area including the whole outer circumference of a resin sealing area. Since the leadframe 2 usually has a guide pin hole near the end side for positioning during resin sealing, it is preferable that sticking be performed in an area not blocking the hole. Further, since a plurality of resin sealing areas are arranged in the longitudinal direction of the leadframe 2, it is preferable that the viscous adhesive tape 1 be continuously stuck over the areas.

On the leadframe 2 described above, a semiconductor chip 3, i.e., a silicon wafer chip as semiconductor integrated circuit part, is mounted. On the leadframe 2, a fixing area referred to as a die pad is provided for fixing the semiconductor chip 3. As the method for bonding (fixing) to the die pad, various methods using a conductive paste, an adhesive tape, or an adhesive are used. When die bonding is performed by using a conductive paste or a thermosetting adhesive, heat curing is usually performed at a temperature of about 150 to 200°C for about 30 minutes to 90 minutes. The leadframe with a semiconductor chip mounted may be subjected to a plasma treatment as shown in Figure 1 (c), in order to remove the dirt of die attach material and the like for improvement in the wire connectivity and the mold/frame adhesion properties.

In a typical method, a wire bonding step for electrically connecting a terminal end of the leadframe to an electrode pad on the semiconductor chip with a bonding wire is subsequently performed. As shown in Figure 1 (d), the wire bonding step is a step of electrically connecting an end of the terminal part (inner lead) of the leadframe 2 to an electrode pad on a semiconductor chip 3 with a bonding wire 4. As the bonding wire 4, for example, a gold wire or an aluminum wire is used. In a typical method, wire connection is performed by using vibrational energy of ultrasonic waves and crimping energy by pressure application in combination, in a heated state at 120 to 250°C. On this occasion, the surface of the adhesive tape 1 stuck to the leadframe 2 is vacuum suctioned, so that the heating block can be securely fixed. Incidentally, although a wire connecting step by face-up mounting of a semiconductor chip is shown above, when face-down mounting of semiconductor chip is performed, a reflow step is appropriately performed.

As shown in Figure 1 (e), the sealing step is a step of sealing one side, i.e., a semiconductor chip side, with a sealing resin 5. The sealing step is performed for protecting the semiconductor chip 3 mounted on the leadframe 2 and the bonding wire 4, typically in a mold with use of a sealing resin such as an epoxy resin, in particular. On this occasion, using a mold including an upper mold and a lower mold having a plurality of cavities, a plurality of sealing resins 5 are subjected to the sealing step at the same time. Specifically, for example, the heating temperature during resin sealing is 170 to 180°C. The resin is cured at the temperature for several minutes, and then further subjected to post mold curing for several hours. Subsequently to the sealing step, as shown in Figure 1 (f), the viscous adhesive tape laminated on the leadframe 2 is peeled. Incidentally, it is preferable that the viscous adhesive tape 1 be peeled before the post mold curing.

As shown in Figure 1 (g), the dicing step is a step of cutting a sealed structure into individual semiconductor devices 10. Examples of the typical step include a dicing step in which the sealing resin 5 is cut at a position by using a rotating cutting blade such as a dicer.

Incidentally, as described above, the viscous adhesive tape in the present embodiment may be laminated on the leadframe before the step of mounting a semiconductor chip, or may be laminated on the leadframe after the step of mounting a semiconductor chip (after wire bonding) and before the sealing step.

Examples

The present invention is described in more detail with reference to Examples and Comparative Examples described below.

The evaluation method and the measurement method each are as follow.

<Acid value>

The acid value was measured by titration of a potassium hydroxide solution. Specifically, the acid value was calculated based on the following equation.

$$Acid\ value\ (mg\ KOH/g) = \{(5.61 \times a \times F)/S\}/(concentration$$

$$of\ non\text{-}volatile\ content/100)$$

S: Amount of sample collected (g), a: Amount of alcoholic solution of 0.1 N potassium hydroxide consumed (ml), F: Titer of 0.1 N potassium hydroxide alcoholic solution

<Weight average molecular weight and molecular weight distribution>

The measurement was performed by gel permeation chromatography (GPC).

<Confirmation of semi-IPN>

Through morphology observation of the cross section of a tack layer, it was confirmed that the tack layer had a semi-IPN structure as follows. In comparison of the area ratio of sea-islands with the mixing ratio of polymers, the ratio of islands was smaller than the ratio of the polymer with a less amount.
More specifically, a thin film piece of the viscous adhesive layer of a viscous adhesive tape was prepared in the thickness direction by a microtome method. A photograph with a magnification of 5000 of the thin film piece thus prepared was taken by an electron microscope (S-4800 manufactured by Hitachi High-Tech Corporation). Based on the sea-island structure thus photographed, X in the following equation was calculated.

$$X = \alpha\ (Area\ ratio)\ /\ \beta\ (Addition\ ratio)$$

$\alpha$ = Area ratio of islands (second acrylic resin) to total area of sea-island structure (total area of first acrylic resin and second acrylic resin)
$\beta$ = Ratio of the amount (part by weight) of a second acrylic resin added to the total amount (part by weight) of a first acrylic resin and the second acrylic resin added
X of 0.9 to 1.0: × (No semi-IPN structure was formed.)
X of less than 0.9: ○ (Semi-IPN structure was formed.)

<Evaluation on pollution properties>

A viscous adhesive tape was roll-laminated (30°C, 0.4 MPa, 1 m/min) on a metal plate plated with NiPdAu, and then heated in a drying machine at 175°C for 6 hours. After heating, the viscous adhesive tape was peeled, and the peeled surface of the tape was analyzed by ESCA (K-Alpha manufactured by Thermo Fisher Scientific, Inc.). From the resulting number concentration of carbon atoms (C) and the number concentration of carbon atoms of the viscous adhesive tape before lamination (D), the value of Y was obtained based on the following for evaluation on the pollution properties.

$$Y = 100 - [C/D \times 100]\ (\%)$$

Y of 10% or less: ○
Y of more than 10% and 20% or less: Δ
Y of more than 20%: ×

<Measurement of peeling strength in hot state>

The viscous adhesive tape was roll-laminated (30°C, 0.4 MPa, 1 m/min) on a glossy surface side of a rolled copper foil (thickness: 35 $\mu$m), and then made into a test piece having a width of 25 mm. The rolled copper foil surface of the resulting test piece and a stainless steel plate were laminated with a double-sided tape, and the resultant was placed in a measurement apparatus having a thermostat chamber [Autograph AGS-500 manufactured by Shimadzu Corporation] under an atmosphere at 150°C for 3 minutes. The viscous adhesive tape was then peeled in the direction of 180°, at a rate of 200 mm/min to measure the peeling strength on this occasion.

75 mN/25 mm or more: ○

50 mN/25 mm or more and less than 75 mN/25 mm: △
less than 50 mN/25 mm: ×

<Measurement of peeling strength after pressing>

The viscous adhesive tape was laminated on a glossy surface side of a rolled copper foil (thickness: 35 μm), heated and pressurized under conditions at 180°C and 3.0 MPa for 60 minutes, and then made into a test piece having a width of 25 mm. The rolled copper foil surface of the resulting test piece and a stainless steel plate were laminated with a double-sided tape, and the viscous adhesive tape was peeled in the direction of 180°, at a rate of 200 mm/min in the measurement apparatus (same as above) to measure the peeling strength on this occasion.

[Synthesis Example 1: Ethyl-2-methyl-2-n-butyltellanylpropionate]

In 50 mL of tetrahydrofuran (THF), 6.38 g (50 mmol) of metal tellurium [manufactured by Aldrich, product name "Tellurium (-40 mesh)"] was suspended, and to the suspension, 34.4 mL (55 mmol) of n-butyl lithium [manufactured by Aldrich, 1.6 mol/L hexane solution] was slowly dripped at room temperature. The reaction solution was stirred until complete disappearance of the metal tellurium. To the reaction solution, 10.7 g (55 mmol) of ethyl-2-bromo-isobutylate was added at room temperature, and the mixture was stirred for 2 hours. After completion of the reaction, the solvent was concentrated under reduced pressure, and subsequently distilled under reduced pressure to obtain 8.98 g of ethyl-2-methyl-2-n-butyltellanyl-propionate as a yellow oily substance (yield: 59.5%).

[Synthesis Example 2: Polymer A]

In a glove box purged with argon, 68 μL (0.28 mmol) of ethyl-2-methyl-2-n-butyltellanyl-propyonate produced in Synthesis Example 1, 130.8 g (1.02 mol) of butyl acrylate, 11.4 g (158 mmol) of acrylic acid, and 4.6 mg (0.03 mmol) of 2,2'-azobis(isobutyronitrile) [AIBN: manufactured by Aldrich] were reacted at 60°C for 20 hours. After completion of the reaction, a reaction vessel was taken out from the glove box, and the reaction product was dissolved in 500 mL of ethyl acetate. The resulting polymer solution was then put through a column containing activated alumina [manufactured by Wako Pure Chemical Corporation]. Ethyl acetate was added to adjust the viscosity of the polymer solution to 7000 mPa·s (25°C), so that a solution of polymer A was obtained.
The solid content of the resulting solution of polymer A was 23.0 mass%.
The polymer A had a weight average molecular weight obtained by gel permeation chromatography (GPC) of 644000, and a molecular weight distribution ($M_W/M_N$) of 1.78. The polymer A had an acid value of 60 mg KOH/g.

[Synthesis Example 3: Polymer B]

A solution of polymer B was obtained by the same method as in Synthesis Example 2, except that the reaction was performed at a ratio of Butyl acrylate:2-Hydroxyethyl acrylate=80:20. The polymer B had a weight average molecular weight of 597000, and a molecular weight distribution ($M_W/M_N$) of 1.82. The polymer B had an acid value of 0 mg KOH/g.

[Synthesis Example 4: Polymer C]

Into a reaction vessel, 100 g of ethyl acetate, 100.0 g (780 mmol) of butyl acrylate, 8.7 g (121 mmol) of acrylic acid, and 0.33 g (2.0 mmol) of 2,2'-azobis(isobutyronitrile) were added, and the mixture was stirred at 70°C. After the elapse of 60 minutes from initiation of the reaction, a part of the reaction solution was taken out every 30 minutes. The reaction was terminated with deionized water. Extraction was performed using methyl ethyl ketone, and the extract was analyzed by gel permeation chromatography (GPC). From the GPC analysis, at a stage when the molecular weight of the reactant reached 500000 or more, the reaction vessel was cooled to terminate the reaction. The resulting mixture was washed with deionized water and dried to obtain a solution of polymer C.
The polymer C had a weight average molecular weight of 814000 obtained by GPC, and a molecular weight distribution ($M_W/M_N$) of 4.77. The polymer C had an acid value of 61 mg KOH/g.

[Synthesis Example 5: Polymer D]

A solution of polymer D was obtained by the same method as in Synthesis Example 2, except that the reaction was performed at a ratio of Butyl acrylate:Acrylic acid = 98:2. The polymer D had a weight average molecular weight of 603000, and a molecular weight distribution ($M_W/M_N$) of 1.96. The polymer D had an acid value of 16 mg KOH/g.

[Synthesis Example 6: Polymer E]

A solution of polymer E was obtained by the same method as in Synthesis Example 2, except that the reaction was performed at a ratio of Butyl acrylate:Acrylic acid=98:2. The polymer E had a weight average molecular weight of 621000, and a molecular weight distribution ($M_W/M_N$) of 4.78. The polymer E had an acid value of 17 mg KOH/g.

[Synthesis Example 7: Polymer F]

A solution of polymer F was obtained by the same method as in Synthesis Example 2, except that 41 $\mu$L (0.17 mmol) of ethyl-2-methyl-2-n-butyltellanyl-propionate was reacted. The polymer F had a weight average molecular weight of 966000, and a molecular weight distribution ($M_W/M_N$) of 1.79. The polymer F had an acid value of 62 mg KOH/g.

[Example 1]

29.3 g (23.0%) of the solution of polymer A, 11.3 g (20.0%) of the solution of polymer B, 0.66 g (0.5 equivalents) of a novolac-type epoxy resin [manufactured by DIC Corporation, Epiclon N730A], an imidazole catalyst [manufactured by Shikoku Chemicals Corporation, Curezol C11Z], and 19 g of methyl ethyl ketone were stirred at room temperature to obtain a composition 1. The composition 1 was applied to a polyimide film (thickness: 25 $\mu$m) to have a thickness after drying of 7 $\mu$m and dried at 150°C for 5 minutes, so that a viscous adhesive tape was obtained. On the tack layer of the viscous adhesive tape, a mold release surface of a mold release-treated mold release film was laminated and heated at 105°C for 24 hours, so that a viscous adhesive tape with a mold release film was obtained.
Using the resulting viscous adhesive tape, each of physical properties was evaluated. The evaluation results are shown in Table 1 (unless otherwise noted, the unit of the content in the table represents "part by mass") .

[Example 2] to [Example 6]

A viscous adhesive tape was produced by the same method as in Example 1, except that the type and the content of each component contained in the compositions of a tack layer was changed to the type and the content shown in Tables 1 to 3, for evaluation of each of physical properties.

[Comparative Example 1] to [Comparative Example 11]

A viscous adhesive tape was produced by the same method as in Example 1, except that the type and the content of each component contained in the composition of a tack layer was changed to the type and the content shown in Tables 1 to 3, for evaluation of each of physical properties.

[Table 1]

| Resin | | | | Example 1 | Example 2 | Example 3 | Comparative Example 1 | Comparative Example 2 | Comparative Example 3 | Comparative Example 4 | Comparative Example 5 |
|---|---|---|---|---|---|---|---|---|---|---|---|
| | Mw [Ten thousand] | Mw/Mn | Acid value | | | | | | | | |
| Polymer A | 64.4 | 1.78 | 60 | 75 | 85 | 65 | 100 | 50 | 95 | 90 | 60 |
| Polymer B | 59.7 | 1.82 | 0 | 25 | 15 | 35 | | 50 | 5 | 10 | 40 |
| Polymer C | 81.4 | 4.77 | 61 | | | | | | | | |
| Polymer D | 60.3 | 1.96 | 16 | | | | | | | | |
| Polymer E | 62.1 | 4.78 | 17 | | | | | | | | |
| Polymer F | 96.6 | 1.79 | 62 | | | | | | | | |
| Curing agent (epoxy) [equivalent] | | | | | | | | 0.5 | | | |
| Catalyst | | | | | | | | 0.2 | | | |
| Semi-IPN structure | | | | O | ○ | ○ | × | × | ○ | ○ | ○ |
| Pollution properties [%] | | | | O | O | △ | ○ | × | ○ | ○ | × |
| Peeling strength in hot state [mN/25 mm] | | | | O | △ | ○ | × | △ | × | × | ○ |
| Peeling strength after pressing [mN/25 mm] | | | | 1113 | 1448 | 1143 | 1526 | 1063 | 1502 | 1504 | 1376 |

EP 3 954 746 B1

12

[Table 2]

| Resin | | | | Example 4 | Comparative Example 6 | Comparative Example 7 | Comparative Example 8 | Comparative Example 9 |
|---|---|---|---|---|---|---|---|---|
| | Mw [Ten thousand] | Mw/Mn | Acid value | | | | | |
| Polymer A | 64.4 | 1.78 | 60 | | | 75 | 75 | |
| Polymer B | 59.7 | 1.82 | 0 | 25 | | | | 25 |
| Polymer C | 81.4 | 4.77 | 61 | | 100 | | | |
| Polymer D | 60.3 | 1.96 | 16 | | | 25 | | 75 |
| Polymer E | 62.1 | 4.78 | 17 | | | | 25 | |
| Polymer F | 96.6 | 1.79 | 62 | 75 | | | | |
| Curing agent (epoxy) [equivalent] | | | | | | 0.5 | | |
| Catalyst | | | | | | 0.2 | | |
| Semi-IPN structure | | | | O | × | ○ | ○ | ○ |
| Pollution properties [%] | | | | Δ | ○ | × | × | Δ |
| Peeling strength in hot state [mN/25 mm] | | | | ○ | × | ○ | ○ | × |
| Peeling strength after pressing [mN/25 mm] | | | | 948 | 828 | 1779 | 844 | 628 |

EP 3 954 746 B1

[Table 3]

| Resin | | | Example 5 | Example 6 | Comparative Example 10 | Comparative Example 11 |
|---|---|---|---|---|---|---|
| | Mw [Ten thousand] | Mw/Mn | Acid value | | | | |
| Polymer A | 64.4 | 1.78 | 60 | 75 | 75 | 75 | 75 |
| Polymer B | 59.7 | 1.82 | 0 | 25 | 25 | | |
| Polymer C | 81.4 | 4.77 | 61 | | | | |
| Polymer D | 60.3 | 1.96 | 16 | | | 25 | 25 |
| Polymer E | 62.1 | 4.78 | 17 | | | | |
| Polymer F | 96.6 | 1.79 | 62 | | | | |
| Curing agent (epoxy) [equivalent] | | | | 0.3 | 0.7 | 0.5 | 0.7 |
| Catalyst | | | | 0.2 | | | |
| Semi-IPN structure | | | | ○ | ○ | ○ | ○ |
| Pollution properties [%] | | | | ○ | Δ | × | × |
| Peeling strength in hot state [mN/25 mm] | | | | ○ | Δ | O | ○ |
| Peeling strength after pressing [mN/25 mm] | | | | 1405 | 1255 | 1779 | 1863 |

As shown in Tables 1 to 3, the viscous adhesive tapes in Examples 1 to 6 have compatibility between adhesion properties and pollution resistance, so that it can be seen that prevention of occurrence of burrs of the molding resin in the sealing step and prevention of occurrence of adhesive residues in the tape peeling step can be achieved at the same time.

**Claims**

1. Use of a viscous adhesive tape for production of semiconductor devices, wherein the viscous adhesive tape comprises a tack layer containing a first acrylic resin having an acid value of 30 to 100 mg KOH/g and a second acrylic resin having an acid value of 0 to 10 mg KOH/g,

   wherein a ratio between the first acrylic resin and the second acrylic resin is,
   (First acrylic resin):(Second acrylic resin)=85:15 to 65:35, and
   the first acrylic resin and the second acrylic resin have a semi-interpenetrating polymer network structure, said polymer network structure being a mixture of cross-linked polymer networks,
   wherein the tack layer further contains a curing agent and is obtained by curing the first acrylic resin by the curing agent, and
   wherein the curing agent is an epoxy resin.

2. Use according to claim 1, wherein the first acrylic resin has a molecular weight distribution (Mw/Mn) of 2.0 or less, and the second acrylic resin has a molecular weight distribution (Mw/Mn) of 2.0 or less.

3. Use according to any one of claims 1 to 2, wherein the content of the curing agent is 0.4 to 0.6 equivalents relative to the first acrylic resin.

4. Use according to any one of claims 1 to 3, wherein the tack layer further contains a curing catalyst.

**Patentansprüche**

1. Verwendung eines viskosen Klebebandes zur Produktion von Halbleitervorrichtungen, wobei das viskose Klebeband eine Klebeschicht umfasst, die ein erstes Acrylharz mit einem Säurewert von 30 bis 100 mg KOH/g und ein zweites Acrylharz mit einem Säurewert von 0 bis 10 mg KOH/g enthält,

   wobei ein Verhältnis von dem ersten Acrylharz zu dem zweiten Acrylharz
   (erstes Acrylharz):(zweites Acrylharz) = 85:15 bis 65:35 beträgt, und
   das erste Acrylharz und das zweite Acrylharz eine semiinterpenetrierende Polymernetzwerkstruktur aufweisen, wobei es sich bei dieser Polymernetzwerkstruktur um eine Mischung aus vernetzten Polymernetzwerken handelt,
   wobei die Klebeschicht ferner ein Härtungsmittel enthält und durch ein Härten des ersten Acrylharzes durch das Härtungsmittel erhalten wird, und
   wobei es sich bei dem Härtungsmittel um ein Epoxidharz handelt.

2. Verwendung nach Anspruch 1, wobei das erste Acrylharz eine Molekulargewichtsverteilung (Mw/Mn) von 2,0 oder weniger aufweist und das zweite Acrylharz eine Molekulargewichtsverteilung (Mw/Mn) von 2,0 oder weniger aufweist.

3. Verwendung nach einem der Ansprüche 1 bis 2, wobei der Inhalt des Härtungsmittels 0,4 bis 0,6 Äquivalente relativ zum ersten Acrylharz beträgt.

4. Verwendung nach einem der Ansprüche 1 bis 3, wobei die Klebeschicht ferner einen Härtungskatalysator enthält.


**Revendications**

1. Utilisation d'un ruban adhésif visqueux pour la production de dispositifs à semi-conducteurs, dans laquelle le ruban adhésif visqueux comprend une couche collante contenant une première résine acrylique présentant un indice d'acide de 30 à 100 mg KOH/g et une seconde résine acrylique présentant un indice d'acide de 0 à 10 mg KOH/g, dans laquelle un rapport entre la première résine acrylique et la seconde résine acrylique est :

   (première résine acrylique):(deuxième résine acrylique)=85:15 à 65:35, et
   la première résine acrylique et la seconde résine acrylique ont une structure de réseau semi-interpénétré de polymères, ladite structure de réseau de polymères étant un mélange de réseaux de polymères réticulés,
   dans laquelle la couche collante contient en outre un agent de durcissement et est obtenue par le durcissement de la première résine acrylique par l'agent de durcissement, et
   dans laquelle l'agent de durcissement est une résine époxy.

2. Utilisation selon la revendication 1, dans laquelle la première résine acrylique a une distribution de poids moléculaire (Mw/Mn) de 2,0 ou moins, et la seconde résine acrylique a une distribution de poids moléculaire (Mw/Mn) de 2,0 ou moins.

3. Utilisation selon l'une quelconque des revendications 1 à 2, dans laquelle la teneur en agent de durcissement est de 0,4 à 0,6 équivalent par rapport à la première résine acrylique.

4. Utilisation selon l'une quelconque des revendications 1 à 3, dans laquelle la couche collante contient en outre un catalyseur de durcissement.

(a) Lamination of
    viscous adhesive tape

(b) Mounting of
    semiconductor chip

(c) Plasma treatment

PLASMA TREATMENT

(d) Wire bonding

(e) Resin sealing

(f) viscous adhesive
    tape peeling

(g) Dicing treatment

Fig. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002184801 A
- JP 2010157752 A
- US 2012274881 A
- WO 2009018246 A